# EUROPÄISCHE PATENTSCHRIFT

(11) **EP 0 655 976 B1**
(45) Veröffentlichungstag und Bekanntmachung des Hinweises auf die Patenterteilung: **13.01.1999**
(21) Anmeldenummer: 94916828.0
(22) Anmeldetag: 07.06.1994
(51) Int. Cl.: B32B 31/00, H01L 31/04

(54) **VERFAHREN ZUR HERSTELLUNG FOTOVOLTAISCHER MODULE SOWIE EINE VORRICHTUNG ZUR DURCHFÜHRUNG DIESES VERFAHRENS**
PROCESS AND DEVICE FOR MANUFACTURING PHOTOVOLTAIC MODULES
PROCEDE ET DISPOSITIF DE FABRICATION DE MODULES PHOTOVOLTAIQUES

(30) Priorität: 11.06.1993 AT 11329/93
(43) Veröffentlichungstag der Anmeldung: 07.06.1995
(73) Patentinhaber: ISOVOLTA Österreichische Isolierstoffwerke Aktiengesellschaft, 2355 Wiener Neudorf (AT)
(72) Erfinder: FALK, Johann, A-8053 Graz (AT); PLESSING, Albert, K., A-8302 Brunn 28 (AT)
(86) Internationale Anmeldenummer: AT9400073
(87) Internationale Veröffentlichungsnummer: WO9429106

(56) Entgegenhaltungen:
- EP-A- 0 392 226
- EP-A- 0 442 702
- EP-A- 0 528 566
- WO-A-92/06847
- DE-A- 3 725 007
- DE-U- 9 110 914
- US-A- 4 421 589
- US-A- 4 433 200
- US-A- 4 806 195
- PATENT ABSTRACTS OF JAPAN vol. 15, no. 147 (E-1055) 12. April 1991 & JP,A,03 022 572 (SANYO ELECTRIC CO LTD) 30. Januar 1991
- PATENT ABSTRACTS OF JAPAN vol. 15, no. 333 (M-1150) 23. August 1991 & JP,A,03 126 547 (MATSUSHITA ELECTRIC WORKS LTD) 29. Mai 1991
- DATABASE WPI Week 8611, Derwent Publications Ltd., London, GB; AN 86-073495 & JP,A,61 024 426 (NEC CORP) 23. Februar 1986

## Beschreibung

Die Erfindung betrifft ein Verfahren zur Herstellung fotovoltaischer Module sowie eine Vorrichtung zur Durchführung dieses Verfahrens. Fotovoltaische Module dienen zur elektrischen Energieerzeugung aus Sonnenlicht und bestehen aus einem Laminat, welches als Kernschicht ein Solarzellensystem wie Siliziumzellen enthält. Diese mechanisch nur gering belastbare Kernschicht ist mit Einkapselungsmaterialien umhüllt. Diese können aus ein oder mehreren Schichten aus Glas und/oder Kunststoffolien und/oder Kunststoffolienverbunden bestehen.

### Stand der Technik

Aus der US-A-4,421,589 ist es bekannt, fotovoltaische Module der eingangs genannten Art in einem Vakuumlaminierverfahren herzustellen. Dabei wird in einem Vakuumlaminator, welcher durch eine flexible Membran in zwei Vakuumkammern getrennt ist, in einer der Kammern auf einer Platte ein Stapel, bestehend aus dem Solarzellensystem und den Einkapselungsmaterialien, gegebenenfalls unter Zuhilfenahme von Trennfolien, gebildet. Dabei wird die Temperatur der Platte auf einer Temperatur, welche unterhalb der Erweichungstemperatur der Einkapselungsmaterialien liegt, gehalten. Anschließend werden die beiden Kammern gleichzeitig evakuiert und die Temperatur der Platte auf die Erweichungstemperatur der Einkapselungsmaterialien gebracht. In der Folge wird die obere Vakuumkammer belüftet, sodaß die flexible Membran an den Stapel gepreßt wird. Dadurch wird ein Verbund, bestehend aus dem Solarzellensystem und den Einkapselungsmaterialien gebildet. Durch weitere Temperaturerhöhung werden die Einkapselungsmaterialien ausgehärtet; anschließend wird die Platte rückgekühlt und das Laminat der Vakuumkammer entnommen.

Derartige Vakuumlaminatoren sind allgemein vorbekannt, siehe dazu EP-A-528 566, worin beispielsweise Mehrschichtverbundmaterialien zur Herstellung von gedruckten Leiterplatten erzeugt werden. Auch gemäß DE-U1-9110914 werden gedruckte Leiterplatten in einem Vakuumlaminator hergestellt. Ebenso wie in der US-A-4421589 erfüllen darin die Heizplatten gleichzeitig die Funktion der Kühlplatten bei dem dem Herstellungsverfahren nachgeschalteten Kühlschritt.

Ein Verfahren zum Einkapseln von Mehrschichtverbundmaterialien wird in der US-4 421 589 beschrieben. Auch in diesem Fall wird ein stationärer Vakuumlaminator eingesetzt, worin in der Reaktionskammer einerseits der Vakuumlaminierschritt sowie andererseits der nachgeschaltete Härtungsschritt durchgeführt werden.

Diese bekannte Verfahren sind nun einerseits sehr zeitaufwendig, da in einem Arbeitsschritt jeweils nur ein Mehrschichtverbund bzw. fotovoltaische Modul gefertigt werden kann; sie sind ferner andererseits mit hohen Energieverlusten verbunden, da durchwegs im Vakuumlaminator die eingesetzten Platten sowohl als Heiz- als auch Kühlplatten verwendet werden.

Gemäß der WO-A-92/06847, die den nächstliegenden Stand der Technik bildet, können zwar mehrere fotovoltaische Module in einem einzigen Verfahrensschritt hergestellt werden, da ein mehrlagiges Gestell als Träger für die Vakuumlaminierung mehrerer Modulstapel eingesetzt wird. Dennoch ist auch dieses Verfahren energieaufwendig, da dieses Gestell sowohl für das Vakuumlaminierverfahren bei Raumtemperatur als auch für den Härteschritt bei erhöhten Temperaturen eingesetzt wird. Ebenso wird dasselbe Gestell für den nachgeschalteten Kühlvorgang verwendet. Dadurch ergeben sich - bedingt durch den Temperaturunterschied - zwischen Vakuumlaminieren, Aushärten sowie dem Kühlschritt hohe Energieverluste.

### Darstellung der Erfindung

Es ist daher Aufgabe der Erfindung, die aus dem Stand der Technik bekannten Nachteile zu beseitigen und ein leicht durchführbares Verfahren zur Herstellung fotovoltaischer Module mit geringem Energie- und Zeitaufwand anzugeben.

Erfindungsgemäß wird nun vorgeschlagen, ein Verfahren zur Herstellung fotovoltaischer Module auf Basis eines Laminates, welches als Kernschicht ein Solarzellensystem enthält, das mit Einkapselungsmaterialien aus einem Glas/Kunststoffolienverbund und/oder einem Kunststoffolienverbund umhüllt ist, durchzuführen, welches dadurch gekennzeichnet ist, daß, in einem kontinuierlichen Ablauf, a) ein Modulstapel, welcher aus einem Solarzellensystem, Einkapselungsmaterialien sowie Trennfolien verschlichtet worden ist, auf eine Trägerplatte, deren Temperatur unterhalb der Erweichungstemperatur der in den Einkapselungsmaterialien angeordneten Kunststoff-Siegelschichten gehalten wird, an einer Beladestation aufgebracht wird und daß b) der Modulstapel in einen Vakuumlaminator transportiert wird, welcher anschließend geschlossen und evakuiert wird, und durch Anpressen einer Heizplatte an die wärmeleitende Trägerplatte auf die Erweichungstemperatur der Kunststoff-Siegelschichten erwärmt wird und c) nach dem Belüften des Vakuumlaminators ohne Rückkühlung der Heizplatte der aus dem Modulstapel gebildete Verbund in einen separaten Härteofen transportiert wird, in welchem die Kunststoff-Siegelschichten ausgehärtet werden, sodaß ein Laminat gebildet wird und daß d) das Laminat anschließend in eine separate Kühlzone transportiert und an einer Entnahmestation dem Herstellungsverfahren entnommen wird und daß die Verfahrensschritte a) bis e) simultan und parallel im Taktverfahren durchgeführt werden.

Das erfindungsgemäße Verfahren ermöglicht es, fotovoltaische Module kontinuierlich bei geringem Energieaufwand herzustellen.

Weitere Vorteile der Erfindung bestehen darin, in den Einkapselungsmaterialien als Kunststoff-Siegelschichten Ethylenvinylazetatfolien und/oder Silikonfolien und/oder Gießharze und/oder Pulverharze und/oder Kunststoffgranulate einzusetzen. Ferner bestehen die Schichten in den Einkapselungsmaterialien vorteilhafterweise aus Glas, Kunststoffolien, aus Kunststoffolienverbunden oder aus Verbunden, welche im wesentlichen aus Kunststoffolien bestehen.

Ferner ist das erfindungsgemäße Verfahren dadurch gekennzeichnet, daß der im Einkapselungsmaterial eingesetzte Kunststofffolienverbund, von der Kunststoff-Siegelschicht zur Trennfolie gehend, Polyvinylfluorid, Polyethylenterephthalat und Polyvinylfluorid in Folienform oder eine Primerschicht, Polyethylenterephthalat in Folienform sowie Polyvinylfluorid oder eine Primerschicht, Polyethylenterephthalat in Folienform und Aluminium sowie Polyvinylfluorid aufweist.

Durch die vorteilhafte Auswahl an den in den Einkapselungsmaterialien verwendeten Stoffen wird ein besonders zufriedenstellender Verbund zwischen Solarzelle und Einkapselungsmaterial erreicht.

Ferner ist die Erfindung durch eine Vorrichtung zur Durchführung des Verfahrens zur Herstellung fotovoltaischer Module auf Laminatbasis gekennzeichnet, das aus einer Beladestation und einem Transportsystem besteht, mit welchem die Trägerplatte für den Mo-dulstapel transportierbar ist, einem Vakuumlaminator mit einem feststehenden Oberteil, in welchem eine Gummimembran angebracht ist und einem mittels einer Hydraulikvorrichtung heb- und senkbaren Unterteil, an welchem eine Heizplatte angebracht ist, einem separaten Härteofen, einer separaten Kühlstation und einer Entnahmestation, an der die Trägerplatte über das Transportsystem zur Beladestation rückgeführt werden kann.

Weitere Vorteile der erfindungsgemäßen Vorrichtung sind, daß im Vakuumlaminator im geschlossenen Zustand Vakuumkammern ausgebildet sind. Ferner wird vorteilhafterweise der Druck und die Temperatur im Vakuumlaminator, die Temperatur im Härteofen und die Temperatur in der Kühlstation jeweils über externe Regelungssysteme eingestellt.

Die erfindungsgemäße Vorrichtung ist ferner vorteilhafterweise dadurch gekennzeichnet, daß die Trägerplatte aus einer wärmeleitfähigen Kernschicht und ebenfalls wärmeleitenden Trägerschichten besteht, wobei die Kernschicht ein Glas-Kunststoff-Metallverbund ist und die Trägerschichten aus Metallblechen bestehen. Die erfindungsgemäße Vorrichtung besitzt ferner eine im Laminatorunterteil angeordnete Heizplatte, die ohne Kühlvorrichtung ausgeführt und an den Federelementen 20, 20' angebracht ist.

Die vorteilhaften Ausgestaltungen der erfindungsgemäßen Vorrichtung ermöglichen ein energiesparendes und leicht durchführbares Verfahren.

### Kurze Beschreibung der Zeichnungen

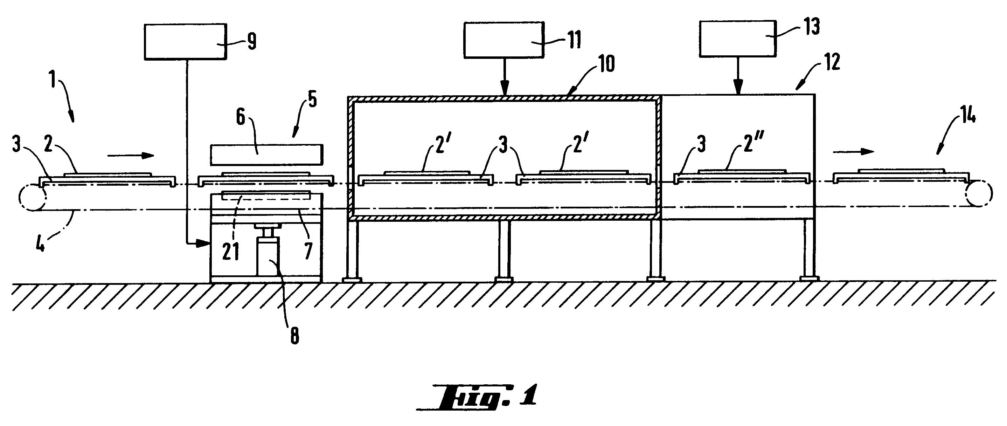

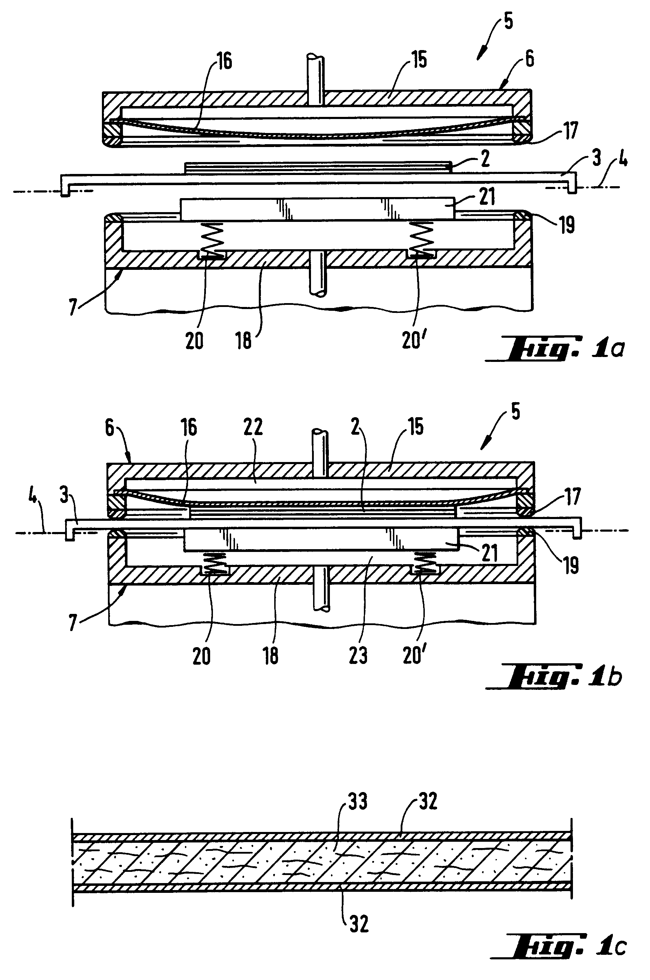

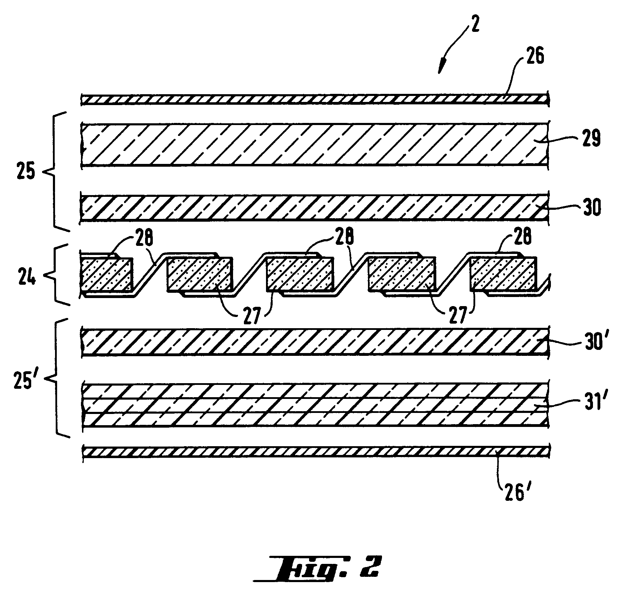

Die Erfindung wird anhand der Figuren 1 und 2 beschrieben:
Fig. 1 zeigt eine Vorrichtung zur Durchführung des erfindungsgemäßen Verfahrens: sie zeigt die Beladestation 1, an der ein Modulstapel 2 auf die Trägerplatte 3, welche mittels des Transportsystems 4 bewegt wird, aufgebracht werden kann sowie den Vakuumlaminator 5 mit dem feststehenden Oberteil 6 und dem über die Hydraulikeinrichtung 8 heb- und senkbaren Unterteil 7. Temperatur, Druck und Verweilzeit werden im Vakuumlaminator 5 über das Regelungssystem 9 eingestellt. Ferner zeigt Fig. 1 den Härteofen 10, dessen Temperatur über das Regelungssystem 11 eingestellt wird, den Kühlbereich 12, dessen Temperatur über das Regelungssystem 13 einstellbar ist und den Entnahmebereich 14.
Fig. 1a zeigt einen Ausschnitt aus dem Vakuumlaminator 5 im geöffneten Zustand sowie die in Fig. 1 nicht sichtbar dargestellten Elemente des Oberteils 6 sowie des Unterteils 7. So enthält das Oberteil 6 das Vakuumkammerteil 15, in welchem eine Gummimembran 16 angebracht ist. Ferner ist das Vakuukammerteil 15 mit einem umlaufenden Dichtungselement 17 ausgestattet. Das Unterteil 7 enthält das Vakuumkammerteil 18, an welchem ebenfalls das umlaufende Dichtungselement 19 angebracht ist. Ferner sind im Vakuumkammerteil 18 die Federelemente 20, 20' angebracht, auf welchen die Heizplatte 21 aufliegt.
Fig. 1b zeigt einen Ausschnitt aus dem Vakuumlaminator 5 im geschlossenen Zustand unter Vakuum. Durch Betätigung der Hydraulikvorrichtung 8 aus Fig. 1 wird das Unterteil des Vakuumlaminators 7 - und damit das Vakuumkammerteil 18 - in Richtung Trägerplatte 3 bewegt, an welche die auf den Federelementen 20, 20' aufliegende Heizplatte 21 gedrückt wird. Ferner liegen durch die Betätigung der Hydraulikvorrichtung 8 die Dichtungselemente 17 und 19 an der Trägerplatte 3 an, sodaß der Vakuumlaminator geschlossen ist und die Vakuukammern 22 und 23 ausgebildet werden.
Fig. 1c zeigt den Schichtaufbau der Trägerplatte 3, welche aus den Trägerschichten 32, 32' und der Kernschicht 33 besteht.
Fig. 2 zeigt den Aufbau des Modulstapels 2, welcher aus dem Solarzellensystem 24 und den das Solarzellensystem umgebenden Einkapselungsmaterialien 25, 25' besteht und welcher an seiner Ober- und Unterseite mit Trennfolien 26, 26' versehen ist. Das Solarzellensystem besteht aus einer Reihe von Siliziumzellen 27, welche in Serie mittels Kontaktierungsdrähten 28 zu Gruppen verlötet sind. Das Einkapselungsmaterial 25' besteht aus der Kunststoff-Siegelschicht 30' und dem Folienverbund 31. Das Einkapselungsmaterial 25 besteht aus der Schicht 29, welche eine Glasschicht wie in Fig. 2 oder ein Folienverbund ähnlich 31 sein kann, und einer Kunststoff-Siegelschicht 30.

### Ein Weg zur Ausführung der Erfindung

Die Erfindung wird nunmehr anhand eines Ausführungsbeispiels näher erläutert:

An der Aufgabestation 1 wird ein Modulstapel 2 auf die Trägerplatte 3, welche auf Raumtemperatur jedoch maximal auf einer Temperatur von 80°C gehalten wird, durch Verschlichten der Einzelkomponenten gemäß Fig. 2 aufgebracht. Als Kunststoff-Siegelschicht 30, 30' werden vorzugsweise Ethylenvinylazetat (EVA)-Folien, Siliconfolien, Gießharze, Pulverharze sowie Kunststoffgranulate verwendet, welche bei Wärmebehandlung geringfügig fließen und in der Folge vernetzen, wodurch das Kriechen der Kunststoffe verhindert wird.

Die Schicht 29 kann aus Glas oder einem Folienverbund, welcher im Aufbau dem Folienverbund 31 ähnlich ist, bestehen. Der Aufbau dieses Folienverbundes ist - beginnend mit der an die Kunststoff-Siegelschichten 30, 30' angrenzende Schicht gemäß den Beispielen a - c in der folgenden Tabelle angeführt.

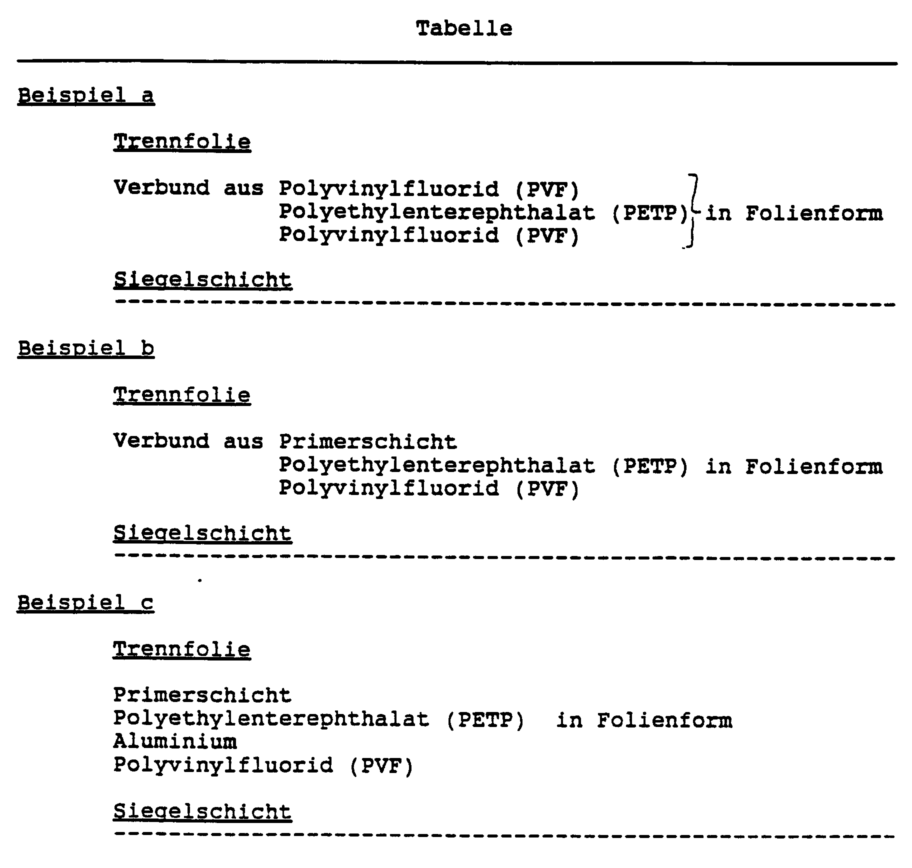

An seiner Ober- und Unterseite ist der Modulstapel mit den Trennfolien 26, 26' versehen, um eine Haftung an der Trägerplatte 3 sowie an den übrigen Anlagenteilen zu vermeiden. Nach der Aufgabe des Modulstapels 2 auf die Trägerplatte 3 wird diese über das Transportsystem 4, beispielsweise einen Kettenförderer in den Vakuumlaminator 5 befördert, dessen Detailansicht im geöffneten Zustand in Fig. 1a wiedergegeben ist. Die Temperatur der Heizplatte 21 wird über ein externes Regelungssystem 9 auf einer Temperatur entsprechend der Erweichungstemperatur der in der Siegelschicht eingesetzten Kunststoffmaterialien gehalten. Durch die Hydraulikvorrichtung 8 wird die Heizplatte 21 gegen die Trägerplatte 3 gedrückt, sodaß - bedingt durch den Wärmestrom innerhalb der Trägerplatte - die Kunststoff-Siegelschichten 30, 30' im Modulstapel auf ihre Erweichungstemperatur gebracht werden. Dieser gezielte Wärmestrom ist ferner dadurch gewährleistet, daß die Trägerplatte im geschlossenen Zustand des Vakuumlaminators gemäß Fig. 1b größtenteils gegen Wärmeabgabe bedingt durch die umlaufenden Dichtungselementen 17 und 19 geschützt ist. Ferner ist der Wärmestrom abhängig von der Wärmeleitfähigkeit der Trägerplatte, welche als Materialkonstante vom Aufbau der Trägerplatte - siehe Fig. 1c - beeinflußt ist. Die Wärmeleitfähigkeit kann durch die Materialauswahl der Kernschicht 33 sowie durch deren Materialdicke eingestellt werden. Als Kernschicht werden Glas-Kunstharz-Verbundmaterialien, welche gegebenenfalls wärmeleitende metallische Zusatzstoffe beinhalten, verwendet. Als Trägerschichten 32, 32' dienen bevorzugt Metalle wie Aluminium oder rostfreies Stahlblech.

Nach dem Schließen des Laminators 5 wird über die externe Regelungseinrichtung 9 ein Vakuum angelegt, sodaß gemäß Fig. 1b die Vakuumkammern 22 und 23 gebildet werden. Durch die Evakuierung werden Luft und sonstige volatile Bestandteile aus dem Modulstapel entfernt, sodaß ein blasenfreies Laminat gewährleistet ist. Anschließend wird die Vakuumkammer 22 belüftet, wodurch die flexible Membran an den Modulstapel gepreßt wird. Nach einer definierten Verweilzeit des Modulstapels 2 im Vakuumlaminator 5 wird die Vakuumkammer 23 belüftet. Es wird ein Verbund 2 zwischen den Komponenten gemäß Fig. 2 erzeugt, der ohne weiteren Preßdruck im Härteofen stabil bleibt. Dieser Verbund passiert anschließend den Härteofen 10, welcher durch das Regelungssystem 11 auf einer definierten Temperatur gehalten wird, wobei die Siegelschichten des Verbundes während einer definierten Verweilzeit aushärten, sodaß das Laminat 2' gebildet wird, welches anschließend in den Kühlbereich 12 transportiert und dort auf Raumtemperatur abgekühlt wird. Dieses ausgehärtete Laminat 2'' wird im Entnahmebereich 14 von der Trägerplatte abgenommen und die rückgekühlte Trägerplatte zur Beladestation 1 rückgeführt.

### Gewerbliche Verwertbarkeit

Die durch das erfindungsgemäße Verfahren hergestellten fotovoltaischen Module dienen zur elektrischen Energieerzeugung aus Sonnenlicht. Ihre Anwendungsmöglichkeiten sind vielfältig und reichen von Kleinenergieanlagen für Notrufsäulen oder Wohnmobile, über Gebäude integrierte Dach- und Fassadenanlagen bis hin zu Großanlagen und Solarkraftwerken.

## Patentansprüche

1. Verfahren zur Herstellung fotovoltaischer Module auf Basis eines Laminates, welches als Kernschicht ein Solarzellensystem enthält, das mit Einkapselungsmaterialien aus einem Glas/ Kunststoffolienverbund und/oder einem Kunststoffolienverbund umhüllt ist, dadurch gekennzeichnet, daß, in einem kontinuierlichen Ablauf,
a) ein Modulstapel 2, welcher aus dem Solarzellensystem (24), den Einkapselungsmaterialien (25, 25') sowie den Trennfolien (26, 26') verschlichtet worden ist, auf eine Trägerplatte (3), deren Temperatur unterhalb der Erweichungstemperatur der in den Einkapselungsmaterialien (25, 25') angeordneten Kunststoff-Siegelschichten (30, 30') gehalten wird, an einer Beladestation (1) aufgebracht wird und daß
b) der Modulstapel (2) in einen Vakuumlaminator (5) transportiert wird, welcher anschließend geschlossen und evakuiert wird, und durch Anpressen einer Heizplatte (21) an die wärmeleitende Trägerplatte (3) auf die Erweichungstemperatur der Kunststoff-Siegelschichten (30, 30') erwärmt wird und daß
c) nach dem Belüften des Vakuumlaminators 5 ohne Rückkühlung der Heizplatte (21) der aus dem Modulstapel gebildete Verbund (2') in einen Separaten Härteofen (10) transportiert wird, in welchem die Kunststoff-Siegelschichten (30, 30')ausgehärtet werden, sodaß ein Laminat (2'') gebildet wird und daß
d) das Laminat (2'') anschließend in eine separate Kühlzone (12) transportiert und
e) an der Entnahmestation (14) dem Herstellungsverfahren entnommen wird,
und daß die Verfahrensschritte a) bis e) simultan und parallel im Taktverfahren durchgeführt werden.

2. Verfahren nach Anspruch 1, dadurch gekennzeichnet, daß in den Einkapselungsmaterialien (25, 25') als Kunststoff-Siegelschichten (30, 30') Ethylenvinylazetatfolien und/oder Silikonfolien und/oder Gießharze und/oder Pulverharze und/oder Kunststoffgranulate eingesetzt werden.

3. Verfahren nach Anspruch 1 oder 2, dadurch gekennzeichnet, daß im Einkapselungsmaterial (25) als Schicht (29) Glas eingesetzt wird.

4. Verfahren nach Anspruch 1 oder 2, dadurch gekennzeichnet, daß im Einkapselungsmaterial (25) als Schicht (29) eine Kunststofffolie eingesetzt wird.

5. Verfahren nach Anspruch 1 oder 2, dadurch gekennzeichnet, daß im Einkapselungsmaterial (25) als Schicht (29) ein Kunststoffolienverbund eingesetzt wird.

6. Verfahren nach einem der Ansprüche 1 bis 5, dadurch gekennzeichnet, daß im Einkapselungsmaterial (25') als Schicht (31) ein im wesentlichen aus Kunststoffolien bestehender Verbund eingesetzt wird.

7. Verfahren nach Anspruch 6, dadurch gekennzeichnet, daß im Einkapselungsmaterial (25') der Kunststoffolienverbund (31), von der Kunststoff-Siegelschicht (30') zur Trennfolie (26') gehend, Polyvinylfluorid, Polyethylenterephthalat und Polyvinylfluorid in Folienform aufweist.

8. Verfahren nach Anspruch 6, dadurch gekennzeichnet, daß im Einkapselungsmaterial (25') der Kunststoffolienverbund (31), von der Kunststoff-Siegelschicht (30') zur Trennfolie (26') gehend, eine Primerschicht, Polyethylenterephthalat in Folienform sowie Polyvinylfluorid aufweist.

9. Verfahren nach Anspruch 6, dadurch gekennzeichnet, daß im Einkapselungsmaterial (25') der Kunststoffolienverbund (31), von der Kunststoff-Siegelschicht (30') zur Trennfolie (26') gehend, eine Primerschicht, Polyethylenterephthalat in Folienform und Aluminium sowie Polyvinylfluorid aufweist.

10. Vorrichtung für die Herstellung fotovoltaischer Module auf Laminatbasis, bestehend aus
a) einer Beladestation (1) und einem Transportsystem (4), mit welchem eine Trägerplatte (3) für den Modulstapel (2) transportierbar ist,
b) einem Vakuumlaminator (5) mit einem feststehenden Oberteil (6), in welchem eine Gummimembran (16) angebracht ist und einem mittels einer Hydraulikvorrichtung (8) heb und senkbaren Unterteil(7), in welchem eine Heizplatte (21) angeordnet ist,
c) einem separaten (10),
d) einer separaten Kühlstation (12) und
e) einer Entnahmestation (14), an der die Trägerplatte (3) über das Transportsystem (4) zur Beladestation rückgeführt werden kann.

11. Vorrichtung nach Anspruch 10 dadurch gekennzeichnet, daß im Vakuumlaminator (5) im geschlossenen Zustand die Vakuumkammern (22, 23) ausgebildet sind.

12. Vorrichtung nach Anspruch 10 oder 11, dadurch gekennzeichnet, daß der Druck und die Temperatur im Vakuumlaminator (5) über das externe Regelungssystem (9) einstellbar sind, daß die Temperatur im Härteofen (10) über das externe Regelungssystem (11) und die Temperatur in der Kühlstation (12) über das externe Regelungssystem (13) einstellbar sind.

13. Vorrichtung nach einem der Ansprüche 10 bis 12, dadurch gekennzeichnet, daß die Trägerplatte aus der wärmeleitfähigen Kernschicht (33) und den ebenfalls wärmeleitenden Trägerschichten (32, 32') besteht.

14. Vorrichtung nach Anspruch 13, dadurch gekennzeichnet, daß die Kernschicht (33) ein Glas-Kunststoff-Metallverbund ist.

15. Vorrichtung nach Anspruch 11, dadurch gekennzeichnet, daß die Trägerschichten (32, 32') aus Metallblechen bestehen.

16. Vorrichtung nach einem der Ansprüche 10 bis 15, dadurch gekennzeichnet, daß die im Laminatorunterteil (7) angeordnete Heizplatte (21) ohne Kühlvorrichtung ausgeführt ist.

17. Vorrichtung nach einem der Ansprüche 10 - 16, dadurch gekennzeichnet, daß die im Laminatorunterteil (7) angeordnete Heizplatte (21) an den Federelementen (20, 20') angebracht ist.

## Claims

1. A method for manufacturing a laminated photovoltaic module of which the core layer is a system of solar cells clad by encapsulating materials consisting of a glass/plastic foil composite and/or a plastic-foil composite,
characterized in that in a continuous process run
(a) a module-stack 2 formed by the solar-cell system 24, the encapsulating materials 25, 25' and the spacing foils 26, 26' and is deposited at a loading station 1 onto a carrier plate 3, the temperature of said plate being kept below the softening point of the plastic sealing layers 30, 30' mounted in the encapsulating materials 25, 25', and
(b) the module-stack 2 is moved into a vacuum laminator 5 which then is closed and evacuated, said stack then being heated to the softening point of the plastic sealing layers 30, 30' by pressing a heater plate 21 against the thermally conducting carrier plate 3 and
(c) following airing of the vacuum laminator 5 and without cooling the heater plate 31, the composite 2' formed from the module-stack is moved into a separate hardening oven 10 wherein the plastic sealing layers 30, 30' are hardened so that a laminate 2'' is formed and
(d) the laminate 2'' thereupon is moved into a separate cooling zone 12 and
(e) said laminate is removed from the manufacturing process at the removal station 14, and in that the process steps (a) through (e) are carried out simultaneously and parallelly in timed manner.

2. Process defined in claim 1, characterized in that ethylenevinyl acetate foils and/or silicone foils and/or casting resins and/or powder resins and/or plastic granulates are used as the plastic sealing layers 30, 30' in the encapsulating materials 25, 25'.

3. Process defined in either of claims 1 and 2, characterized in that the layer 29 in the encapsulating material 25 is glass.

4. Process defined in either of claims 1 and 2, characterized in that the layer 29 in the encapsulating material 25 is a plastic foil.

5. Process defined in either of claims 1 and 2, characterized in that the layer 29 in the encapsulating material 25 is a plastic foil composite.

6. Process defined in one of claims 1 through 5, characterized in that the layer 31 in the encapsulating material 25' is a composite essentially consisting of plastic foils.

7. Process defined in claim 6, characterized in that seen in the direction from the plastic sealing layer 30' toward the spacing foil 26', the plastic foil composite 31 in the encapsulating material 25' comprises polyvinyl fluoride, polyethylene terephthalate and polyvinyl fluoride in foil form.

8. Process defined in claim 6, characterized in that seen in the direction from the plastic sealing layer 30' toward the spacing foil 26' the plastic foil composite 31 in the encapsulating material 25' comprises a primer layer, polyethylene terephthalate in foil form and polyvinyl fluoride.

9. Process defined in claim 6, characterized in that seen from the plastic sealing layer 30' toward the spacing foil 26', the plastic foil composite 31 in the encapsulating material 25' comprises a primer layer, polyethylene terephthalate in foil form and aluminum and polyvinyl fluoride.

10. A device for manufacturing laminated photovoltaic modules, consisting of
(a) a loading station 1 and a conveyor 4 moving a carrier plate 3 of the module-stack 2,
(b) a vacuum laminator 5 with a stationary upper part 6 housing a rubber membrane 16 and a lower part 7 which can be raised and lowered by hydraulic device 8 and housing a heater plate 21,
(c) a separate hardening oven 10,
(d) a separate cooling station 12 and
(e) a removal station 14 from which the conveyor 4 is able to return the carrier plate 3 to the loading station.

11. A device defined in claim 10, characterized in that the vacuum chambers 22, 23 are formed in the vacuum laminator 5 when in the closed state.

12. A device defined in either of claims 10 and 11, characterized in that the external regulator 9 controls the temperature and pressure in the vacuum laminator 5, in that the temperature in the hardening oven 10 is controlled by the external regulator 11 and the temperature in the cooling system 12 by the external regulator 13.

13. A device defined in one of claims 10 through 12, characterized in that the carrier plate consists of the thermally conductive core layer 33 and of the carrier layers 32, 32' which also are thermally conducting.

14. A device defined in claim 13, characterized in that the core layer 33 is a glass/plastic/metal composite.

15. A device defined in claim 11, characterized in that the carrier layers 32, 32' are sheetmetal 5.

16. A device defined in one of claims 10 through 15, characterized in that the heater plate 21 mounted in the laminator lower part 7 lacks a cooling system.

17. A device defined in one of claims 10 through 16, characterized in that the heater plate 21 mounted in the laminator lower part 7 is affixed to the springs 20, 20'.

## Revendications

1. Procédé de fabrication de modules photovoltaïques, sur la base d'un stratifié, contenant à titre de couche de noyau ou centrale un système de cellules solaires, enveloppé par des matériaux d'encapsulation constitués d'un composite verte/feuil de matière synthétique et/ou d'un composite de feuils de matière synthétique, caractérisé en ce que, selon un processus continu :
a) un empilement de modules (2), constitué du système de cellules solaires (24), des matériaux d'encapsulation (25, 25'), ainsi que des feuilles de séparation (26, 26'), est disposé sur une plaque support (3) dont la température est inférieure à la température de ramollissement des couches de scellement en matière synthétique (30, 30') disposées dans les matériaux d'encapsulation (25, 25'), est transporté à un poste de chargement (1), et en ce que
b) l'empilement de modules (2) est transporté dans une machine à stratifier sous vide (5) qui est ensuite fermée et mise en dépression, par pressage d'une plaque chauffante (21) sur la plaque support (3) à bonne conductibilité thermique, est chauffé à la température de ramollissement des couches de scellement en matière synthétique (30, 30'), et en ce que
c) après aération de la machine à stratifier sous vide (5) sans nouveau refroidissement de la plaque chauffante (21), le composite (2') constitue des empilements de modules est transporté dans un four de durcissement (10) séparé, dans lequel les couches de scellement en matière synthétique (30, 30') sont durcis de façon à former un stratifié (2''), et en ce que
d) le stratifié (2'') est ensuite transporté dans une zone de refroidissement (12) séparée, et
e) est prélevé du processus de fabrication, au poste de prélèvement (14), et en ce qu'on met en oeuvre les étapes de procédé a) à e) selon un processus rythmé, simultanément et parallèlement.

2. Procédé selon la revendication 1, caractérisé en ce que, dans les matériaux d'encapsulation (25, 25'), sont insérés à titre de couches de scellement en matière synthétique (30, 30') des feuilles en acétate d'éthylène vinyle et/ou des feuilles de silicone et/ou des résines à mouler, et/ou des résines en poudre et/ou des granulés de matière synthétique.

3. Procédé selon la revendication 1 ou 2, caractérisé en ce que du verte est utilisé comme couche (29) dans le matériau d'encapsulation (25).

4. Procédé selon la revendication 1 ou 2, caractérisé en ce que dans le matériau d'encapsulation (25) est utilisé comme couche (29) une feuille de matière plastique.

5. Procédé selon la revendication 1 ou 2, caractérisé en ce que dans le matériau d'encapsulation (25) est utilisé comme couche (29) un composite constitué de feuilles de matière synthétique.

6. Procédé selon l'une des revendications 1 à 5, caractérisé en ce qu'un composite constitué essentiellement de feuilles de matière synthétique, est utilisé comme couche (31) dans le matériau d'encapsulation (25').

7. Procédé selon la revendication 6, caractérisé en ce que, dans le matériau d'encapsulation (25'), le composite en feuilles de matière synthétique (31) présente. en allant de la couche de scellement en matière synthétique (30') à la feuille de séparation, du fluorure du polyvinyle, du terepthalate de polyéthylène et du fluorure de polyvinyle sous forme de feuilles.

8. Procédé selon la revendication 6, caractérisé en ce que, dans le matériau d'encapsulation (25'), le composite de feuilles de matière synthétique (31) présente. en allant de la couche de scellement en matière synthétique (30) à la feuille de séparation (26'), une couche de fond, du téréphtalate de polyéthylène sous forme de feuilles, ainsi que du fluorure de polyvinyle.

9. Procédé selon la revendication 6, caractérisé en ce que, dans le matériau d'encapsulation (25'), le composite en feuilles de matière synthétique (31) présente. en allant de la couche de scellement en matière synthétique (30') à la feuille de séparation (26'), une couche de fond, du téréphtalate de polyéthylène sous forme de feuille, et de l'aluminium ainsi que du fluorure de polyvinyle.

10. Dispositif de fabrication de modules photovoltaïques à base de stratifiés, constitué :
a) d'un poste de chargement (1) et d'un système de transport (4), avec lequel une plaque support (3) destinée à l'empilement de modules (2) peut être transportée,
b) d'une machine à stratifier sous vide (5), comportant une partie supérieure fixe (6), dans laquelle est montée une membrane en élastomère (16) et une partie inférieure (7) susceptible d'être levée et abaissée au moyen au moyen d'un organe hydraulique (8) et dans lequel est disposée une plaque chauffante (21),
c) d'un four de durcissement (10) séparé,
d) d'un poste de refroidissement (12) séparé, et
e) d'un poste de prélèvement (14) où la plaque support (3) peut être retournée au poste de chargement par l'intermédiaire du système de transport (4).

11. Dispositif selon la revendication 10, caractérisé en ce que les chambres à dépression (22, 23) sont réalisées dans la machine à stratifier sous vide (5) à l'état fermé.

12. Dispositif selon la revendication 10 ou 11, caractérisé en ce que la pression et la température dans la machine à stratifier sous vide (5) sont réglables par l'intermédiaire du système de régulation externe (9), en ce que la température dans le four de durcissement (10) est réglable par l'intermédiaire du système de régulation externe (11) et la température dans le poste de refroidissement (12) est réglable par l'intermédiaire du système de régulation externe (13).

13. Dispositif selon l'une des revendications 10 à 12, caractérisé en ce que la plaque support est constituée de la couche centrale de noyau (33) à bonne conductivité thermique et des couches support (32, 32') également à bonne conductibilité thermique.

14. Dispositif selon la revendication 13, caractérisé en ce que la couche centrale de noyau (33) est un composite métallique verre/matière synthétique.

15. Dispositif selon la revendication 11, caractérisé en ce que les couches support (32, 32') sont constituées de tôles métalliques.

16. Dispositif selon l'une des revendications 10 à 15, caractérisé en ce que la plaque chauffante (21) disposée dans la partie inférieure de la machine à stratifier (7) est réalisée sans dispositif de refroidissement.

17. Dispositif selon l'une des revendications 10 à 16, caractérisé en ce que la plaque chauffante (21) disposée dans la partie inférieure de la machine à stratifier (7) est montée sur les éléments élastiques (20, 20').
